**Europäisches Patentamt**

**European Patent Office**

**Office européen des brevets**

(11) Numéro de publication: **0 018 249**
**A1**

(12) # DEMANDE DE BREVET EUROPEEN

(21) Numéro de dépôt: **80400394.5**

(22) Date de dépôt: **25.03.80**

(51) Int. Cl.³: **G 03 B 41/00, G 02 B 19/00**

(30) Priorité: **23.04.79 FR 7910209**

(43) Date de publication de la demande: **29.10.80**
**Bulletin 80/22**

(84) Etats contractants désignés: **CH DE GB IT NL SE**

(71) Demandeur: **"THOMSON-CSF" - SCPI, 173, Boulevard Haussmann, F-75360 Paris Cedex 08 (FR)**

(72) Inventeur: **Dubroeucq, Georges, "THOMSON-CSF" SCPI 173, Bld Haussmann, F-75360 Paris Cedex 08 (FR)**
Inventeur: **Lacombat, Michel, "THOMSON-CSF" SCPI 173, Bld Haussmann, F-75360 Paris Cedex 08 (FR)**
Inventeur: **Brevignon, Michèle, "THOMSON-CSF" SCPI 173, Bld Haussmann, F-75360 Paris Cedex 08 (FR)**

(74) Mandataire: **Wang, Pierre et al, "THOMSON-CSF" - SCPI 173, bld. Haussmann, F-75360 Paris Cedex 08 (FR)**

(54) Dispositif illuminateur destiné à fournir un faisceau d'éclairement divergent à partir d'une zône prédéterminée d'un plan et système de transfert de motifs comprenant un tel dispositif.

(57) La présente invention concerne un dispositif illuminateur destiné à fournir un faisceau d'éclairement divergent (100) à partir d'une zone de dimensions et de distribution énergétique prédéterminées.

Le dispositif comprend une source cohérente (1) dont on forme l'image dans un plan (S) par des moyens optiques comprenant des moyens optiques de balayage ($M_x$, $M_y$, $L_1$–$L_3$) commandés électriquement permettant de déplacer l'image dans ladite zone selon une loi prédéterminée.

L'invention s'applique notamment au transfert de motifs lors de la réalisation des circuits intégrés.

EP 0 018 249 A1

1

## DISPOSITIF ILLUMINATEUR DESTINE A FOURNIR UN FAISCEAU D'ECLAIREMENT DIVERGENT A PARTIR D'UNE ZONE PREDETERMINEE D'UN PLAN ET SYSTEME DE TRANSFERT DE MOTIFS COMPRENANT UN TEL DISPOSITIF.

La présente invention concerne un dispositif illuminateur destiné à fournir un faisceau d'éclairement divergent à partir d'une zone de dimensions et de distribution énergétique prédéterminées.

La fabrication des circuits intégrés implique la réalisation d'une superposition de niveaux dans un substrat semiconducteur (silicium ou AsGa par exemple). Pour cela, on réalise sur le substrat des fenêtres permettant de localiser l'implantation ou le traitement, par masquage d'une résine photosensible déposée sur le substrat à partir d'un masque. La technique actuellement la plus employée est le transfert par projection optique.

Cette projection peut être réalisée à l'échelle 1 : le masque est globalement projeté sur le substrat. Elle peut être également réalisée par partition de l'image, soit en analysant le masque par une fente mobile, soit en employant la technique de photorépétion, avec réduction d'échelle.

Dans le cas de cette dernière technique, il est nécessaire, en production, d'optimiser le débit de fabrication, notamment en réduisant le temps d'exposition nécessaire pour une bonne insolation. Il est connu d'obtenir une réduction sensible de ce temps en utilisant une source laser.

Le laser constitue une source d'éclairement particulière de par sa cohérence spatiale et temporelle. Son emploi dans un dispositif optique de projection d'image entraîne l'apparition d'un bruit de cohérence important. Il est donc nécessaire pour obtenir une image avec un bon rapport signal sur bruit de modifier la nature de l'éclairement. Pour ce faire, on peut mett en oeuvre un dispositif visant à moyenner les figures d'interférence engendrées par la cohérente du faisceau. On peut notamment utiliser un diffuseur tournant placé sur le trajet du faisceau d'éclairement. L'inconvénient de ce diffuseur est qu'il introduit une perte d'énergie lumineuse très importante, ce qui détruit partiellement les avantages apportés par la grande puissance disponible d'un laser.

L'invention propose un dispositif offrant un très bon rendement lumineux, en créant une source dont on pe régler à volonté le degré de cohérence. Plus généralement, l'invention vise à synthétiser une source de form et de distribution énergétique réglables, cette source étant réalisée à partir d'une source laser et pouvant être mise en oeuvre non seulement dans un photorépéteur mais dans de nombreux dispositifs de formation d'images où l'on désire utiliser les avantages de la cohérence spatiale, tout en éliminant le bruit de cohérence.

L'invention a donc pour objet un dispositif illumi nateur destiné à fournir un faisceau d'éclairement divergent à partir d'une zone prédéterminée d'un plan, ce dispositif comprend une source de rayonnement et des moyens optiques permettant de former l'image de cette source dans le plan, principalement caractérisé en ce que la source est cohérente et en ce que les moyens opt: ques comprennent des moyens optiques de balayage comman dés électriquement permettant de déplacer l'image dans ladite zone selon une loi prédéterminée.

L'invention vise également un système de transfert de motifs comprenant un tel dispositif illuminateur.

D'autres caractéristiques et avantages de l'invention apparaîtront mieux à l'aide de la description ci-après, présentée à titre d'exemple non limitatif, et des figures annexées parmi lesquelles :

- la figure 1 est un schéma d'un système optique d'éclairement d'un objet selon l'art connu ;

- la figure 2 montre la distribution d'intensité de l'image d'un trait par différents types d'éclairement ;

- la figure 3 représente un dispositif selon l'invention ;

- la figure 4 montre des exemples de sources synthétisées ;

- la figure 5 est un schéma explicatif;

- la figure 6 illustre l'application de l'invention à un photorépéteur ;

- la figure 7 est un diagramme montrant l'intérêt de l'invention quant au rapport signal sur bruit.

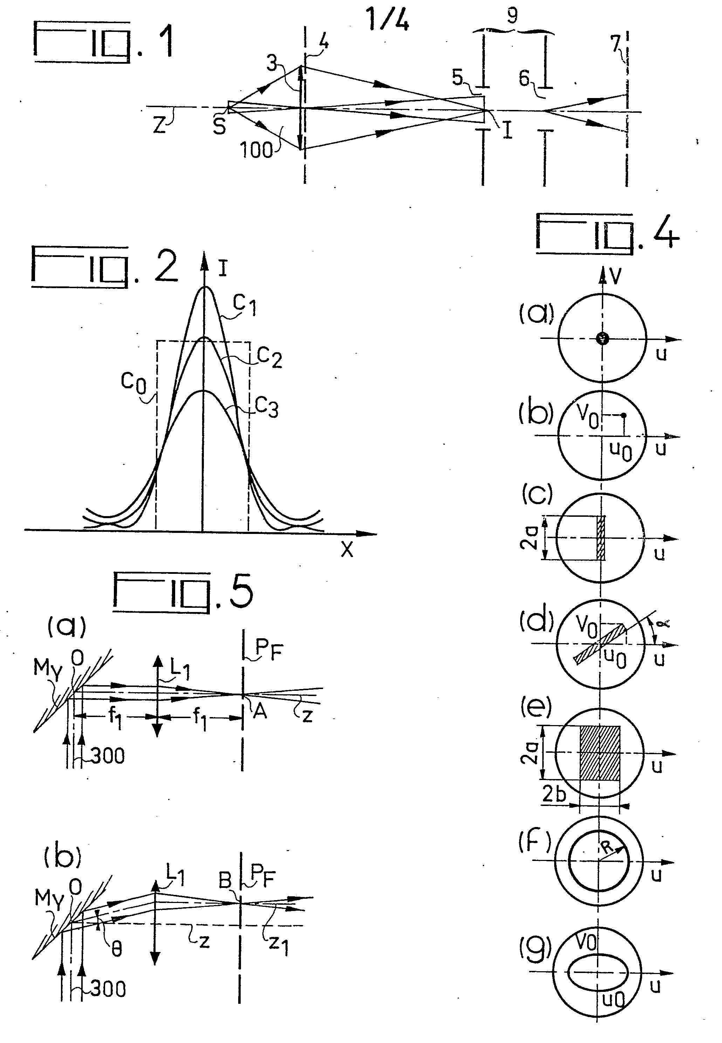

La figure 1 est un schéma d'un système optique d'éclairement d'un objet à partir d'une source S délivrant un faisceau lumineux 100 d'axe Z. Un objet 4, qui peut être une plaque photographique, un masque ou tout objet formé de zones transparentes et de zones opaques, est éclairé par le faisceau. Devant cet objet, est disposé un condenseur 3 permettant de condenser le faisceau 100 vers la pupille d'entrée 5 d'un objectif 9. Le plan de la pupille 5 coïncide avec le plan de focalisation du faisceau 100. On forme l'image de l'objet 4 par l'objectif 9, de pupille de sortie 6 dans un plan 7 qui peut être matérialisé, selon le cas, par un écran, ou une couche photosensible, telle qu'une résine déposée sur un substrat de semiconducteur destiné à former un circuit intégré. L'image formée dans le plan 7 dépend fortement des caractéristiques de la source S, notamment de sa cohérence spatiale, c'est-à-dire de ses dimensions. Un paramètre significatif, appelé degré de cohérence partielle, est le rapport $\sigma$ entre le diamètre de l'image I de la source S dans le plan de la pupille 5 et le diamètre de cette pupille. Lorsque la source S est une source parfaitement

4

cohérente, telle qu'un laser, le rapport $\sigma$ est quasi-ment nul. Dans ce cas, tous les points éclairés de l'objet 4 sont corrélés en phase. Dans le plan image, l'image est reconstituée par les interférences entre les ordres de diffraction tous transmis sans atténuati et l'ordre 0. Lorsque les dimensions de la source S augmentent, la corrélation de phase décroît. Certains ordres de diffraction sont partiellement bloqués par la pupille 5, si bien que l'image de l'objet n'est pas reconstituée exactement. L'éclairement est totalement incohérent lorsque les dimensions de la source couvrent totalement la pupille 5 ( $\sigma = 1$), l'éclairement est déjà pratiquement incohérent.

L'influence de la source sur l'image obtenue est montrée à partir d'un exemple. L'objet est une plaque opaque à l'exception d'un trait transparent. La figure est un diagramme de distribution de l'intensité lumineu dans le plan 7, selon une direction X perpendiculaire à la direction du trait, pour différentes sources. Les courbes $C_1$, $C_2$, $C_3$ correspondent respectivement à $\sigma = 0,1$, $\sigma = 0,5$, $\sigma = 1$. On a représenté en $C_0$ l'imag théorique du trait. On constate que plus le degré de cohérence est faible, plus l'intensité recueillie au centre du trait est élevée et plus les flancs de la courbe sont raides. Or, pour obtenir des profils d'images de bonne qualité et une bonne résolution, il est préférable d'avoir des flancs raides.

Les avantages d'une grande cohérence spatiale sur la résolution conduisent à utiliser soit une source inc hérente derrière laquelle on place un diaphragme, soit un laser. Le rendement énergétique très faible obtenu avec une source diaphragmée conduit à préférer le laser Mais la très grande cohérence temporelle de celui-ci crée un bruit de cohérence important et gênant. On peut l'éliminer en augmentant le diamètre de la source,

5

celui-ci restant toutefois faible devant le diamètre de la pupille d'entrée de l'objectif.

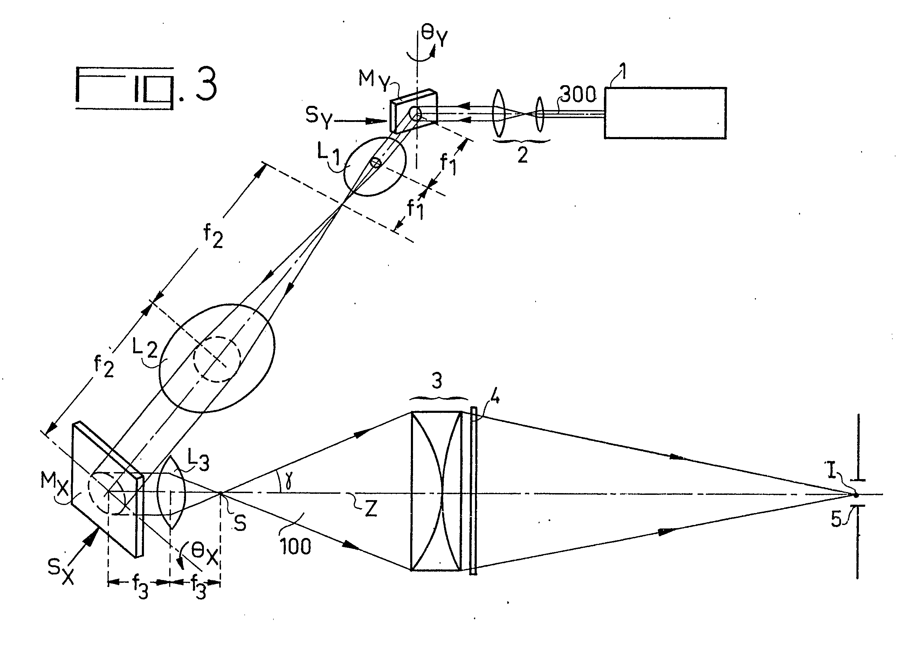

La figure 3 représent un dispositif illuminateur selon l'invention, ce dispositif étant destiné à l'éclairement d'un objet 4. Ce dispositif forme l'image S d'une source laser 1 considérée comme ponctuelle. Le faisceau parallèle 300 délivré par le laser 1 est élargi par un ensemble de lentilles 2 puis réfléchi par un miroir $M_y$ tournant autour d'un axe Oy vers une lentille $L_1$ de distance focale $f_1$. Le faisceau, qui était parallèle, converge donc dans le plan focal de la lentille $L_1$. Une deuxième lentille $L_2$ de distance focale $f_2$ est disposée derrière la lentille $L_1$, de façon que son plan focal objet coïncide avec le plan focal image de $L_1$. On obtient donc à nouveau à la sortie de la lentille $L_2$ un faisceau parallèle qui est réfléchi par un deuxième miroir $M_x$ tournant autour d'un axe $\theta_x$. Une troisième lentille $L_3$ permet de former en S l'image du laser. Lorsque les miroirs $M_x$ et $M_y$ sont fixés, la source synthétisée est ponctuelle et coïncide avec le foyer de la lentille $L_3$. Les directions des axes de rotation $\theta_x$ et $\theta_y$ sont choisies de façon que l'effet de la rotation des miroirs $M_x$ et $M_y$ soit un déplacement du point S dans le plan focal image de la lentille $L_3$, respectivement selon deux directions perpendiculaires. Les distances focales des lentilles $L_1$, $L_2$, $L_3$ sont choisies de façon à obtenir l'ouverture souhaitée, $\gamma$ pour le faisceau issu de la source S. Les miroirs $M_x$, $M_y$ sont par exemple des miroirs galvanométriques commandés respectivement par des signaux électriques $S_x$ et $S_y$. Ceux-ci peuvent être sinusoïdaux, en dents de scie, voire quelconques. Les amplitudes de rotation données aux miroirs déterminent les amplitudes de déplacement du point S. Les périodes d'oscillation doivent être petites par rapport aux temps d'observation ou d'exposition prévus. On définit pendant un temps donné T la forme et la distribution énergétique de la source synthétisée de la façon suivante : Pendant le temps T, le point S décrit une courbe en fonction des signaux $S_x$ et $S_y$ ; cette courbe définit une surface $\Sigma$ qui donne la forme de la source. Chaque point de la surface de coordonnées u, v a une certaine brillance $B_o$ mais il n'est occupé par le point S que pendant un certain temps $\delta t$. Sa distribution énergétique s'écrit $B(u, v) = B_o \cdot (\frac{\delta t}{T})$. Connaissant la courbe décrite par le point S et sa dérivée par rapport au temps, il est possible de calculer la fonction $B(u, v)$. On peut montrer que la source ainsi synthétisée par balayage de la surface $\Sigma$ par le point S est équivalente à une source incohérente (il s'agit de l'incohérence temporelle), de même forme et de même distribution énergétiq

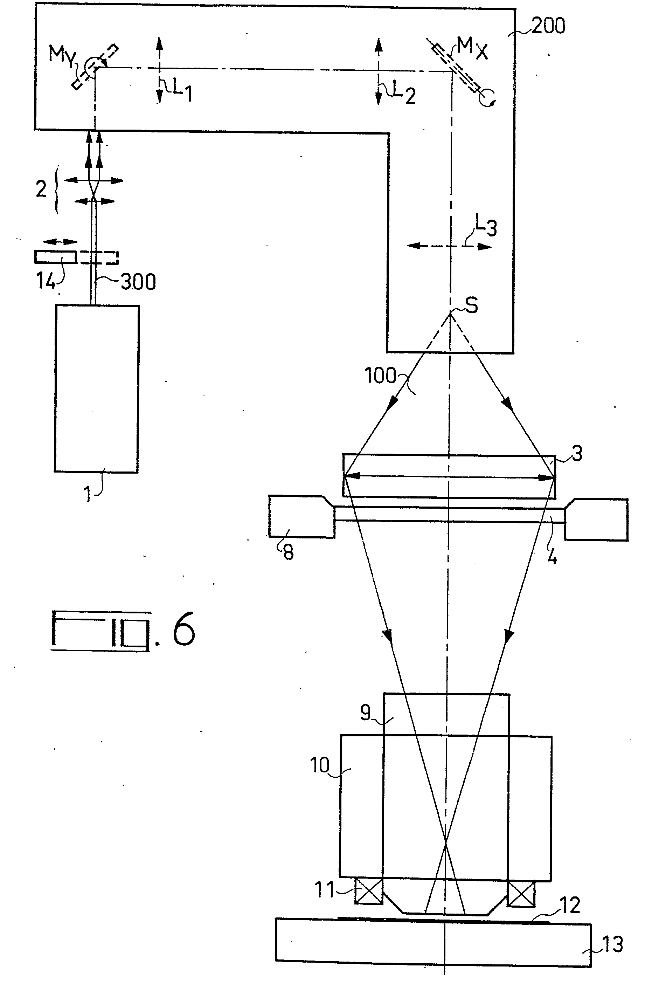

Des exemples de sources que l'on peut synthétiser sont représentés sur la figure 4. En (a), il s'agit d'une source cohérente centrée, obtenue lorsque les signaux $S_x$ et $S_y$ sont nuls. En (b), il s'agit d'une source cohérente décentrée, obtenue lorsque $S_x$ et $S_y$ sont des constantes non nulles $u_o$, $v_o$. En (c), on a une source linéaire de longueur 2a selon l'axe v, obtenue avec $S_x = 0$ et $S_y = a \cos \omega t$. Le dispositif peut, dans ce cas, ne comprendre qu'un seul miroir. En (d), on a une source linéaire formant un angle $\alpha$ avec l'angle u, obtenue avec $S_x = u_o \cos \omega t$ et $S_y = v_o \cos \omega t$. En (e), on a une source rectangulaire de côtés 2a et 2b, obtenue par un balayage du type balayage de télévision, avec $S_y = b \sin \omega_y t$ et pour $S_x$ un signal périodique de pulsation $\omega_x$ grande par rapport à $\omega_y$, par exemple une sinusoïde d'amplitude a, ou un signal en dents de scie. En (f) est représentée une source annulaire de rayon $R_o$, obtenue avec $S_x = R_o \cos \omega t$ et $S_y = R_o \sin \omega t$. En (g), la source es elliptique, obtenue avec $S_x = u_o \cos \omega t$ et $S_y = v_o \sin$

7

Comme on peut le voir sur la figure 3, les emplacements des miroirs $M_x$ et $M_y$ sur le chemin optique ne sont pas quelconques. Il est en effet préférable, pour éviter les aberrations et les pertes de lumière au niveau du condenseur 3, non seulement que les déplacements du point S soient de faible amplitude par rapport au diamètre du condenseur, mais de plus, que l'axe du faisceau suivant sur le condenseur soit toujours parallèle à son axe optique. Ainsi, le faisceau lumineux divergent qui arrive sur le condenseur reste toujours pratiquement centré par rapport à ce dernier et il n'y a pas de pertes de lumière. Pour obtenir ce parallélisme, l'invention prévoit de placer chaque miroir de façon que son axe de rotation passe par le foyer de la lentille qui le suit. Le meilleur des cas est celui où l'axe de rotation est entièrement contenu dans le plan focal. C'est le cas du miroir $M_y$. Ainsi, lorsque le miroir pivote, le point I décrit une droite dans le plan de la pupille 5. La figure 5 montre le trajet du faisceau incident 300 et du faisceau réfléchi sur le miroir $M_y$. En (a), le miroir $M_y$ est en position moyenne : l'axe z du faisceau converge dans le plan focal PF en A, qui est le foyer de la lentille. En (b), le miroir ayant tourné d'un angle $\theta/2$ par rapport à la position précédente, autour d'un axe perpendiculaire au plan de la figure et passant par le foyer objet O de la lentille $L_1$, l'axe du faisceau réfléchi forme un angle $\theta$ avec l'axe optique de la lentille $L_1$. Le faisceau se focalise toujours dans le plan PF, en un point B. Une construction optique simple montre que l'axe $z_1$ du faisceau issu de la lentille est parallèle à l'axe optique z et distant de celui-ci d'une valeur égale à $f_1 \times tg\,\theta$. Le même raisonnement pourrait être fait pour le miroir $M_x$, dans une direction perpendiculaire.

En fait, des nécessités pratiques de réalisation ont conduit, pour le dispositif représenté sur la figu: 3, à ne pas respecter cette position de l'axe de rotation pour le miroir $M_x$. Lorsque ce miroir pivote, le point I décrit un axe de parabole dans le plan de la pupille. Toutefois, les amplitudes de rotation restant toujours faibles (typiquement inférieures à 0,1 rad.), les écarts maximaux obtenus par rapport à la droite idéale sont très faibles (écart relatif inférieur à 4 %). D'autre part, l'axe du faisceau lumineux ne rest€ parallèle à l'axe optique des lentilles que lorsqu'il passe par les foyers des lentilles, ce qui est le cas pour la figure 3. Si ne n'est pas le cas, l'axe du faisceau reste parallèle à une direction fixe non paral lèle à l'axe optique.

L'invention s'applique principalement à l'impression sur une résine photosensible d'un motif porté par un masque, au moyen d'un photorépéteur. La figure 6 représente un photorépéteur utilisant un disposif 200 de synthèse d'une source S selon l'invention. Le laser 1 est par exemple un laser à Krypton de puissance 2 W dont le diagramme de rayonnement comporte deux raies très fines à 413 nm et 415 nm. Sur le trajet du faisceau 300 sont disposés successivement un obturateur rapide 14 par lequel est déterminée la durée nécessaire d'éclairement T; puis les différents éléments de la figure 3, référencés de la même façon : les lentilles 2, l'ensemble 200 constitué par les miroirs $M_y$ et $M_x$ et les lentilles $L_1$, $L_2$, $L_3$, cet ensemble fournissant la source S délivrant le faisceau divergent 100 éclairant toute la surface du condenseur 3. Pour cela, la lentille $L_3$ a une grande ouverture et une faible distance focale. Derrière le condenseur 3 sont disposés le masque 4 porté par un porte-objet 8, l'objectif 9 porté par un porte-objectif 10 et muni de capteurs 11 assurant une mise au point automatique. Un substrat

9

semiconducteur 12 recouvert de photoresist est placé dans le plan image. Il est porté par une table 13 assurant les déplacements selon deux directions perpendiculaires, en vue de la répétition du motif porté par le masque. Les origines de bruit les plus importantes dans ce type de dispositif sont :

    - parmi les bruits dûs à l'objet : le bruit de phase dû à l'inhomogénéité d'épaisseur et éventuellement d'indice de réfraction du masque et le bruit impulsionnel généré par les défauts du masque, qui est un bruit blanc ne dépendant pas de la cohérence.

    - parmi les bruits dûs à l'objectif de projection : le bruit aléatoire dû à la diffusion dans le verre des lentilles. En éclairement cohérent, la source étant quasi-ponctuelle et la cohérence temporelle très grande, le bruit de phase et le bruit de diffusion s'additionnant en tout point du plan image en amplitude et en phase. Lorsqu'on utilise le balayage selon l'invention, on réduit le bruit de diffusion en agrandissant l'image de la source dans la pupille d'entrée de l'objectif et on réduit le bruit de phase en faisant varier, pendant le temps d'exposition, la phase de l'onde éclairant le masque. Dans le cas d'une source circulaire ou annulaire, telle que celle représentée en (f) sur la figure 4, la valeur théorique de la surface de l'image I de la source dans la pupille d'entrée de l'objectif est $\Sigma_o = \pi \left(\frac{1,22\lambda}{2 \cdot ON}\right)^2$ où $\lambda$ est la longueur d'onde du faisceau lumineux et ON l'ouverture numérique de l'objectif qui est inversement proportionnelle au diamètre de la source S. En pratique, la valeur réelle $\Sigma_1$ de cette surface est très supérieure à $\Sigma_0$, en raison des aberrations des lentilles.

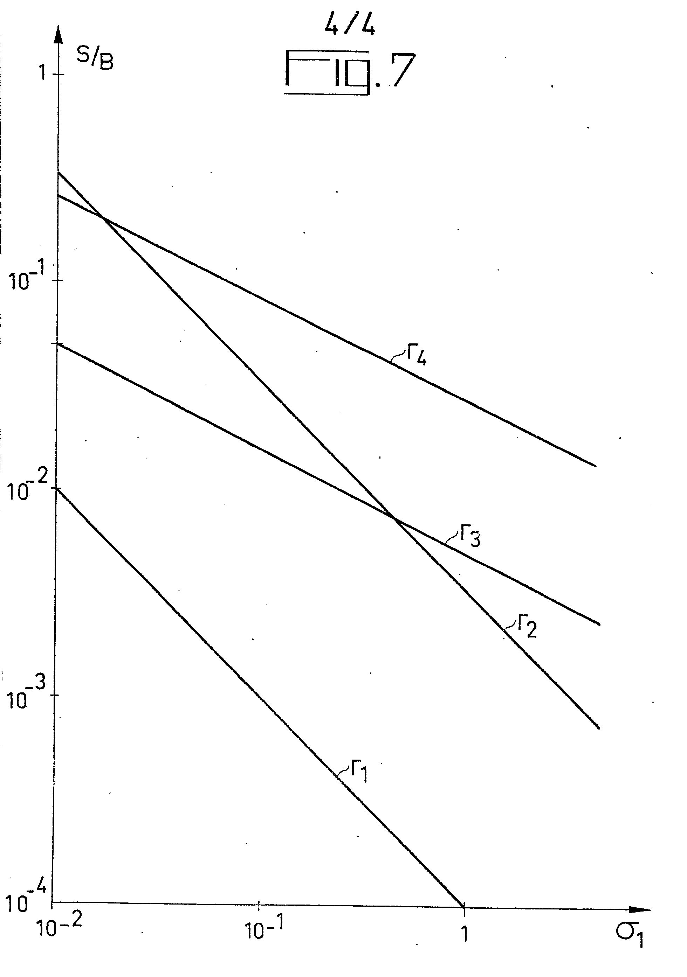

    La figure 7 représente les variations du rapport signal sur bruit S/B en fonction du degré de cohérence réel $\sigma_1$, c'est-à-dire du rapport entre le diamètre réel

10

de l'image I et le diamètre de la pupille. Les quatres courbes $\Gamma_1$ à $\Gamma_4$ correspondent respectivement à une so circulaire avec $\Sigma_1 = \Sigma_0$ et $\Sigma_1 = \Sigma_0 \cdot 10^{-3}$ et à une source annulaire avec $\Sigma_1 = \Sigma_0$ et $\Sigma_1 = \Sigma_0 \cdot 10^{-3}$. On constate que le bruit décroît rapidement lorsque le diamètre de la source croît. Compte tenu des caractéristiques des résines photosensibles, avec $\sigma_1$ de l'ordre de $10^{-1}$, le bruit n'a plus d'effet sur l'impressio de la résine et la cohérence spatiale est encore très grande, ce qui permet d'en conserver les avantages quai à la résolution. Par ailleurs, la grande puissance du laser utilisée permet des temps d'exposition très courts.

L'invention peut être utilisée, non seulement pou la photorépétition, mais aussi notamment dans les syst mes de projection à l'échelle 1 et les systèmes de pro jection catadioptriques.

0018249

11

REVENDICATIONS

1. Dispositif illuminateur destiné à fournir un faisceau d'éclairement divergent (100) à partir d'une zone prédéterminée d'un plan (S), ce dispositif comprenant une source de rayonnement (1) et des moyens optiques permettant de former l'image de cette source dans le plan (S), caractérisé en ce que la source (1) est cohérente et en ce que les moyens optiques comprennent des moyens optiques de balayage commandés électriquement permettant de déplacer l'image dans ladite zone selon une loi prédéterminée.

2. Dispositif selon la revendication 1, caractérisé en ce que les moyens optiques de balayage comprennent deux miroirs pivotants ($M_x$, $M_y$) sous la commande de signaux électriques ($S_x$, $S_y$), et dont les axes de pivotement ($\Theta_x$, $\Theta_y$) ont des directions différentes.

3. Dispositif selon la revendication 2, caractérisé en ce que les faisceaux réfléchis par les miroirs ($M_x$, $M_y$) sont des faisceaux parallèles.

4. Dispositif selon la revendication 3, caractérisé en ce que les moyens optiques comprennent en outre deux lentilles ($L_1$, $L_2$) disposées entre les deux miroirs ($M_x$, $M_y$) et ayant leur axe optique commun et un foyer commun et une troisième lentille ($L_3$) faisant converger le faisceau parallèle issu du deuxième miroir sur le plan ($M_x$).

5. Dispositif selon la revendication 4, caractérisé en ce que la zone réfléchissante des miroirs est située respectivement au foyer de la première ($L_1$) et de la troisième ($L_3$) lentille, de façon que, lors du balayage, l'axe du faisceau issu du plan soit parallèle à une direction fixe (Z).

6. Dispositif selon l'une quelconque des revendications 1 à 5, caractérisé en ce que ladite zone est un rectangle, les signaux électriques ($S_x$, $S_y$) de commande

des miroirs étant des signaux périodiques de fréquence différente.

7. Dispositif selon l'une quelconque des revendications 1 à 5, caractérisé en ce que ladite zone est un cercle.

8. Dispositif selon l'une quelconque des revendications 1 à 5, caractérisé en ce que ladite zone est un anneau.

9. Dispositif selon l'une quelconque des revendications 1 à 5, caractérisé en ce que ladite zone est un trait.

10. Système de transfert de motifs permettant de reproduire l'image d'un objet (4) à transparence non uniforme sur un support (12) recouvert d'une couche photosensible, ce système comprenant un dispositif illuminateur (200) fournissant un faisceau divergent (100) de façon à couvrir toute la surface d'un objet (4), un condenseur (3) disposé devant l'objet (4) destiné à faire converger le faisceau vers la pupille d'entrée d'un objectif (9), cet objectif formant l'image de l'objet (4) sur le support (12), le système étant caractérisé en ce que le dispositif illuminateur (200) est selon l'une quelconque des revendications précédentes, les dimensions de la zone balayée étant telles que son image dans la pupille d'entrée de l'objectif soit plus petite que ladite pupille.

0018249

FIG. 3

FIG. 6

0018249

4/4

Fig.7

## RAPPORT DE RECHERCHE EUROPEENNE

**Office européen des brevets**

0018249
Numéro de la demande

EP 80 40 0394

### DOCUMENTS CONSIDERES COMME PERTINENTS

| Catégorie | Citation du document avec indication, en cas de besoin, des parties pertinentes | Revendication concernée |
|---|---|---|
|  | FR - A - 2 104 599 (SIEMENS) <br> * Revendications 1-3,8-10 * | 1,2 |
|  | US - A - 3 985 439 (H.KIEMLE) <br> * Résumé; figures * | 1 |
| A | US - A - 3 794 421 (I. KANO) <br> * Colonne 2, lignes 22-62 * | 1 |
| A | FR - A - 2 109 747 (IBM) <br> * Page 4, lignes 1-21; page 6, lignes 5-33 * | 1 |

----

**CLASSEMENT DE LA DEMANDE (Int. Cl.)**

G 03 B 41/00
G 02 B 19/00

**DOMAINES TECHNIQUES RECHERCHES (Int. Cl.)**

G 02 B 19/00
27/18
G 03 B 41/00

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achevement de la recherche | Examinateur |
|---|---|---|
| La Haye | 18-07-1980 | PFAHLER |

EB Form 1503.1    06.78